# FASCICULE DE BREVET EUROPEEN

(11) **EP 0 767 916 B1**
(45) Date de publication et mention de la délivrance du brevet: **08.04.1998**
(21) Numéro de dépôt: 95924369.2
(22) Date de dépôt: 27.06.1995
(51) Int. Cl.: G01R 15/24, G01R 29/14, G01D 5/26

(54) **TRANSDUCTEUR ELECTRO-OPTIQUE DE HAUTE IMPEDANCE**
ELEKTROOPTISCHER WANDLER MIT HOHER IMPEDANZ
HIGH-IMPEDANCE ELECTRO-OPTIC TRANSDUCER

(30) Priorité: 28.06.1994 FR 9407947
(43) Date de publication de la demande: 16.04.1997
(73) Titulaire: COMMISSARIAT A L'ENERGIE ATOMIQUE, 75015 Paris (FR)
(72) Inventeur: CHARRA, Fabrice, F-91460 Marcoussis (FR)
(74) Mandataire: Dubois-Chabert, Guy
(86) Numéro de dépôt international: FR9500852
(87) Numéro de publication internationale: WO9600904

(56) Documents cités:
- EP-A- 0 254 601
- CPEM '88 DIGEST, 7 Juin 1988 TSUKUBA, IBARAKI, JP, pages 89-90, MAHMOUD A. EL-SHERIF 'ON-FIBER SENSOR AND MODULATOR'

## Description

La présente invention concerne un transducteur électro-optique de haute impédance.

Elle s'applique notamment aux capteurs à sortie optique.

Les capteurs sont des composants qui assurent l'interface d'entrée de divers systèmes : ils convertissent une grandeur à mesurer (grandeur chimique, mécanique ou électromagnétique par exemple) en une grandeur directement utilisable par l'unité de traitement d'information de ces systèmes, c'est-à-dire une grandeur électrique ou optique.

Les capteurs à sortie optique présentent les avantages reconnus suivants :
- insensibilité aux perturbations électromagnétiques,
- possibilité de déport de la mesure par fibres optiques,
- aptitude à la miniaturisation.

Cependant, le développement bien antérieur des capteurs à sortie électrique reste plus avancé.

On a toutefois envisagé d'associer à un capteur à sortie électrique un transducteur électro-optique afin d'obtenir une sortie optique.

Par exemple, des capteurs optiques de pression ont été réalisés en associant à une cale piézoélectrique (capteur mécanique à sortie électrique) une diode électroluminescente qui fournit alors une sortie optique.

La miniaturisation des capteurs à sortie optique pose des problèmes de sensibilité liés à la limitation de l'énergie disponible.

En effet, les microcapteurs à sortie optique ne disposent généralement que de l'énergie fournie par le signal à mesurer lui-même (capteurs dits "autogénérateurs") ou d'une énergie lumineuse amenée par un guide d'onde de sonde (capteurs dits "optoalimentés").

Les capteurs optiques de pression cités ci-dessus sont autogénérateurs.

Par ailleurs, de nombreux capteurs à sortie optique sont fondés sur des mesures de photoluminescence (voir le document (1) qui, comme les autres documents cités par la suite, est mentionné à la fin de la présente description), la lumière excitatrice étant transmise à un tel capteur par le même guide d'onde que celui qui recueille la lumière de photoluminescence : ces capteurs à sortie optique sont alimentés optiquement.

Or, l'énergie fournie par le signal à mesurer est en général proportionnelle à la taille du capteur.

Par exemple, l'énergie électrique fournie par une cale piézoélectrique est proportionnelle à la surface de cette cale.

Un transducteur électro-optique à associer à un microcapteur à sortie électrique (ou utilisé lui-même comme capteur électrique) doit donc consommer très peu d'énergie électrique.

Cela signifie qu'il doit présenter une très haute impédance d'entrée.

Actuellement, les transducteurs électro-optiques intégrés qui présentent les plus hautes impédances d'entrée sont les modulateurs basés sur l'effet électro-optique.

Ces transducteurs :
a1) nécessitent des matériaux orientés (cristaux ou polymères polarisés) pour leur fabrication,
a2) nécessitent une lumière de sonde cohérente (laser),
a3) nécessitent l'utilisation de guides d'ondes monomodes,
a4) ont une capacité d'entrée supérieure à 5 pF pour une modulation de 50% avec une tension de 10 V,
a5) admettent des fréquences pouvant atteindre 1 GHz,
a6) permettent le multiplexage de cohérence (voir le document (2)).

Il a été proposé des transducteurs électro-optiques appelés "luministors" qui sont fondés sur les variations de photoluminescence de polymères conducteurs, variations qui sont dues au dopage-dédopage (oxydation-réduction) induit par un potentiel électrique (voir le document (3)).

Ces transducteurs n'ont pas à satisfaire aux conditions a1) à a3) mentionnées ci-dessus.

Cependant :
b1) leur sensibilité reste faible, ce qui impose une grande capacité d'entrée (supérieure à 5 pF) pour obtenir un signal suffisant,
b2) les fréquences admises par ces transducteurs sont limitées à quelques herz.

La présente invention a pour objet un transducteur électro-optique qui ne présente pas ces deux inconvénients b1) et b2).

De façon précise, la présente invention a pour objet un transducteur électro-optique comprenant un élément électro-sensible qui est sujet à l'émission d'un rayonnement de photoluminescence lorsqu'il est éclairé par un rayonnement d'excitation, ce transducteur étant caractérisé en ce que l'élément électro-sensible comprend des oligomères conjugués photoluminescents, ces derniers étant sujets à une variation de leur rendement de photoluminescence en présence d'un champ électrique.

Le transducteur électro-optique objet de l'invention est fondé sur les variations de photoluminescence que présente une certaine classe de molécules (les oligomères conjugués photoluminescents) lorsque ces molécules sont soumises à un champ électrique.

Le transducteur objet de l'invention présente une sensibilité beaucoup plus grande que celle des luministors (dans lesquels les molécules ne sont pas directement sensibles au champ électrique mais sont sensibles à la présence de charges électriques).

Il présente une capacité d'entrée de l'ordre d'une centaine de femtofarads et il est susceptible d'admettre des fréquences supérieures à 1 GHz.

Ce transducteur permet donc la réalisation de capteurs électriques optiquement alimentés à sortie optique.

Il permet aussi de donner une sortie optique alimentée optiquement à des microcapteurs autogénérateurs à sortie électrique.

Certains capteurs chimiques à sortie optique sont fondés sur la diminution de la photoluminescence de fluorophores, cette diminution étant produite par l'action des molécules à détecter (voir le document (1)).

Dans de tels capteurs, chaque molécule captée supprime la photoluminescence d'un fluorophore.

Comme on le verra mieux par la suite, dans certains modes de réalisation particuliers, le transducteur objet de l'invention permet de supprimer la luminescence de plusieurs centaines de fluorophores par molécule captée, d'où un effet d'amplification de la sensibilité par rapport à ces capteurs chimiques connus.

Le transducteur objet de l'invention a d'autres domaines d'application que celui des capteurs.

Sa faible énergie de commutation et sa large bande passante sont utiles dans le domaine de la transmission optique d'informations.

La lumière modulée étant incohérente, il ne peut s'agir que d'une transmission à courte distance (quelques mètres), par exemple sur un bus optique.

De plus, la possibilité de réalisation de transducteurs conformes à l'invention ayant de grandes surfaces, avec des énergies de commande raisonnables, conduit à des applications dans le domaine des écrans et des dispositifs d'affichage.

Dans la présente invention, lesdits oligomères peuvent être choisis dans un premier groupe comprenant les oligomères de paraphénylène et les oligomères de thiophène, le nombre N de monomères de ces oligomères étant tel que 8≤N≤12.

On peut également choisir ces oligomères dans un deuxième groupe comprenant les oligomères de paraphénylène-éthénylène et les oligomères de thiophène-éthénylène, le nombre N de monomères de ces oligomères étant tel que 4≤N≤10.

De préférence, le nombre de monomères de ces oligomères est égal à 8 dans le premier cas et à 4 dans le deuxième, en vue d'obtenir l'impédance d'entrée la plus haute possible.

Selon un premier mode de réalisation particulier du transducteur objet de l'invention, l'élément électro-sensible comprend une couche contenant lesdits oligomères et des moyens d'application d'un champ électrique macroscopique à cette couche.

Les moyens d'application du champ électrique peuvent comprendre deux électrodes respectivement placées de part et d'autre de la couche.

Au moins une partie de l'une des deux électrodes peut être transparente au rayonnement d'excitation et au rayonnement de photoluminescence.

Selon un deuxième mode de réalisation particulier du transducteur objet de l'invention, l'élément électro-sensible comprend en outre des molécules ionophores aptes à capter sélectivement des ions déterminés, chaque ion capté créant un champ électrique microscopique auquel sont soumis lesdits oligomères.

Dans ce cas, dans une réalisation particulière, le transducteur comprend en outre un guide d'onde optique destiné à la propagation du rayonnement d'excitation et du rayonnement de photoluminescence et l'élément électro-sensible est fixé à une extrémité de ce guide d'onde.

Dans une autre réalisation particulière correspondant également à ce cas, le transducteur comprend en outre un guide d'onde optique destiné à la propagation du rayonnement d'excitation et du rayonnement de photoluminescence et l'élément électro-sensible est fixé sur le pourtour du guide d'onde, le couplage de l'élément électro-sensible avec ce guide d'onde étant un couplage par ondes évanescentes.

La présente invention sera mieux comprise à la lecture d'exemples de réalisation donnés ci-après, à titre purement indicatif et nullement limitatif, en faisant référence aux dessins annexés sur lesquels :
- la figure 1 est une vue schématique d'un mode de réalisation particulier du transducteur électro-optique objet de l'invention, comprenant une couche d'oligomères conjugués photoluminescents entre deux électrodes, dont l'une comprend au moins une zone transparente pour l'excitation de la couche et la récupération du rayonnement de photoluminescence,
- la figure 2 est une vue schématique d'une variante de réalisation du transducteur de la figure 1 dans laquelle l'excitation de la couche et la récupération du rayonnement de photoluminescence se font par la tranche de la couche,
- la figure 3 est une vue schématique d'un autre mode de réalisation particulier du transducteur électro-optique objet de l'invention, dans lequel les oligomères conjugués photoluminescents se trouvent à l'extrémité d'un guide d'onde optique, et
- la figure 4 est une vue schématique d'une variante de réalisation du transducteur de la figure 3, dans laquelle les oligomères se trouvent sur le pourtour du guide d'onde.

On rappelle que la photoluminescence est un phénomène d'émission de lumière, à une longueur d'onde λF, par un matériau excité par éclairement à une longueur d'onde λE inférieure à λF.

Le rendement de photoluminescence est le rapport du nombre de photons absorbés par le matériau au nombre de photons réémis par ce matériau.

Le fonctionnement du transducteur objet de l'invention est fondé sur la diminution du rendement de photoluminescence d'un matériau décrit dans ce qui suit, sous l'action d'un champ électrique (et non par dopage comme dans les luministors).

Les molécules organiques capables d'absorber la lumière aux longueurs d'ondes du domaine visible sont celles qui possèdent un système d'électrons π conjugués, c'est-à-dire des électrons délocalisés, susceptibles de se déplacer sur plusieurs atomes.

L'absorption d'un photon par un tel système se traduit par la génération d'états excités.

La nature de ces états dépend fortement de la taille du système d'électrons conjugués.

Dans les petites molécules telles que la fluorescéine (dont un dérivé est utilisé dans le document (2)), l'état excité atteint est un état dit singulet.

Un tel état a une très forte probabilité de réémettre un photon en retournant dans l'état fondamental.

C'est le phénomène de fluorescence.

Pour de très grands systèmes conjugués, tels que ceux que possèdent le polythiophène et le polyphénylène-éthénylène, qui sont des polymères semi-conducteurs, l'excitation optique se traduit par la génération d'une paire électron-trou.

Les charges de cette paire sont susceptibles de se déplacer le long du système conjugué, donnant naissance au phénomène de photoconductivité.

Or, lorsqu'elle se recombine, une paire électron-trou n'a qu'une probabilité de 25% de former un état singulet fluorescent (et 75% de former un état triplet non-fluorescent).

Ces polymères ont donc un rendement de photoluminescence plus faible que les fluorophores à petit système conjugué tels que la fluorescéine.

La photoconductivité réduit le rendement de fluorescence.

Dans la présente invention, on utilise des oligomères conjugués photoluminescents (fluorophores électro-sensibles) de taille intermédiaire entre les fluorophores classiques, formés de petites molécules, et les polymères semi-conducteurs.

On utilise par exemple les oligomères de paraphénylène dont la formule est indiquée en a) ci-dessous, avec un nombre n1 de monomères qui est tel que 8≤n1≤12, ou les oligomères de thiophène dont la formule est indiquée en b) ci-dessous, également avec un nombre nl de monomères tel que 8≤n1≤12.

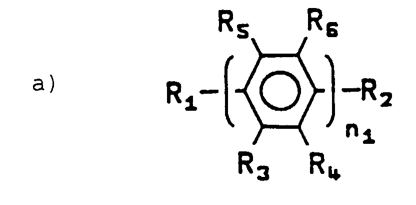

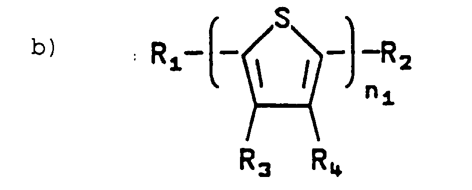

Dans l'invention, on peut aussi utiliser les oligomères de paraphénylène-éthénylène qui sont également appelés paraphénylènes-vinylènes et dont la formule est indiquée en c) ci-dessous, avec un nombre n2 de monomères tel que 4≤n2≤10, ou les oligomères de thiophène-éthénylène dont la formule est indiquée en d) ci-dessous, également avec un nombre n2 de monomères tel que 4≤n2≤10.

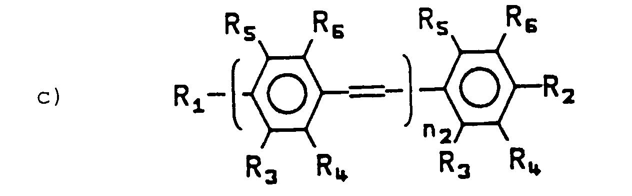

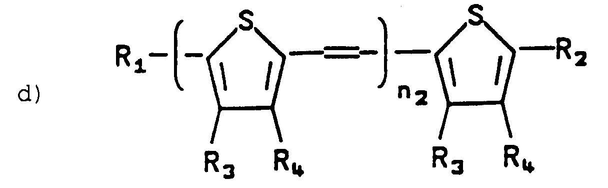

Ces oligomères, dont les formules sont indiquées en a), b), c) et d), présentent un rendement de fluorescence intermédiaire entre celui d'un fluorophore comme le terthiophène (formule b) avec n1=3) ou le stilbène (formule c) avec n2=1) et celui d'un polymère.

Dans les oligomères utilisés dans l'invention, la photogénération directe d'un état singulet fluorescent ou la création d'une paire électron-trou indépendants, paire qui est peu fluorescente, ont des probabilités voisines l'une de l'autre.

Ces deux voies de relaxation sont donc concurrentes.

On a trouvé que ces probabilités sont fortement dépendantes de la présence d'un champ électrique : un tel champ favorise fortement la séparation en paires électron-trou sous l'effet du rayonnement d'excitation, ce qui a pour effet de réduire le rendement de fluorescence.

L'intensité lumineuse émise par fluorescence sous excitation optique d'intensité constante constitue donc une sonde du champ électrique subi par ces oligomères.

Par ailleurs, le mouvement de charges dans un champ électrique consomme l'énergie de ce champ électrique.

En d'autres termes, la présence de charges mobiles dans un matériau augmente la conductivité de celui-ci et en réduit donc l'impédance électrique.

Dans la présente invention, l'utilisation d'oligomères de taille réduite diminue la mobilité des charges et minimise de ce fait la consommation d'énergie.

On utilise donc, de préférence, des oligomères correspondant à la formule a) ou à la formule b) avec un nombre n1 de monomères égal à 8, ou des oligomères correspondant à la formule c) ou à la formule d) avec un nombre n2 de monomères égal à 4.

On a toutefois trouvé que pour des oligomères du type c) non substitués, les valeurs n2=4 ou n2=5 ou n2=6 constituaient un bon compromis.

De tels oligomères voient leur rendement de photoluminescence diminué de 40% sous l'effet d'un champ électrique de 2x10⁵ V/cm.

Dans les formules a), b), c) et d), R1 à R6 représentent des groupes quelconques (pourvu que ces groupes n'altèrent pas les chaînes conjuguées).

Dans le cas le plus simple, R1 à R6 représentent des atomes d'hydrogène.

Cependant, les oligomères des formules a), b), c) et d) peuvent être substitués.

En particulier, les groupes R₁ à R₆ des formules a), b, c) et d) peuvent être :
- des groupes électro-donneurs (par exemple amino ou méthoxy) ou des groupes électro-accepteurs (par exemple nitro ou cyano), de sorte qu'on est capable de modifier les longueurs d'onde d'excitation et d'émission des oligomères en modifiant ces groupes,
- ou des réticulants, c'est-à-dire des ponts chimiques covalents permettant d'attacher les oligomères les uns aux autres ou d'attacher ces oligomères à un polymère-hôte comme par exemple le PMMA de sorte qu'on est capable de modifier les propriétés mécaniques du matériau contenant les oligomères en modifiant ces réticulants,
- ou des groupements solubilisants permettant de rendre ce matériau, ou une partie de celui-ci, soluble dans le solvant désiré, en particulier pour la réalisation de couches de type Langmuir-Blodgett dont l'intérêt apparaîtra plus loin.

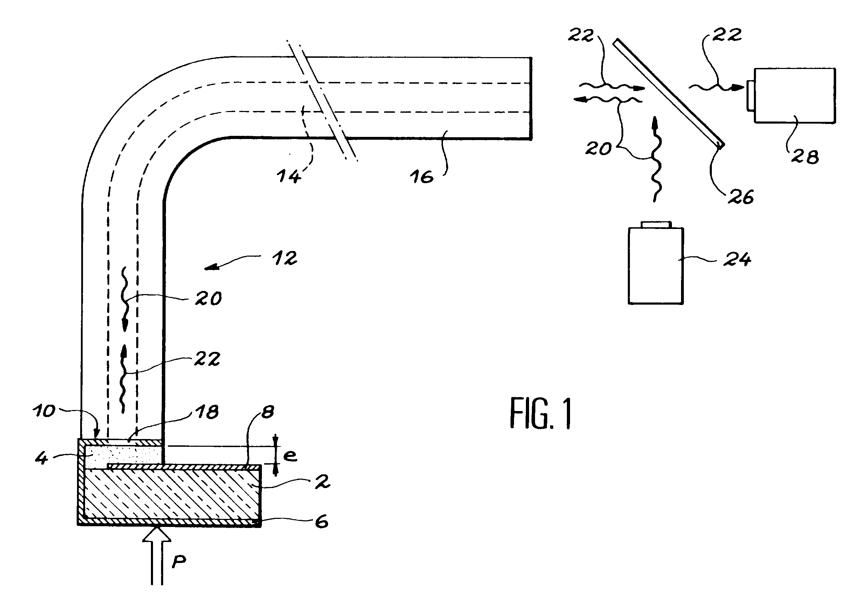

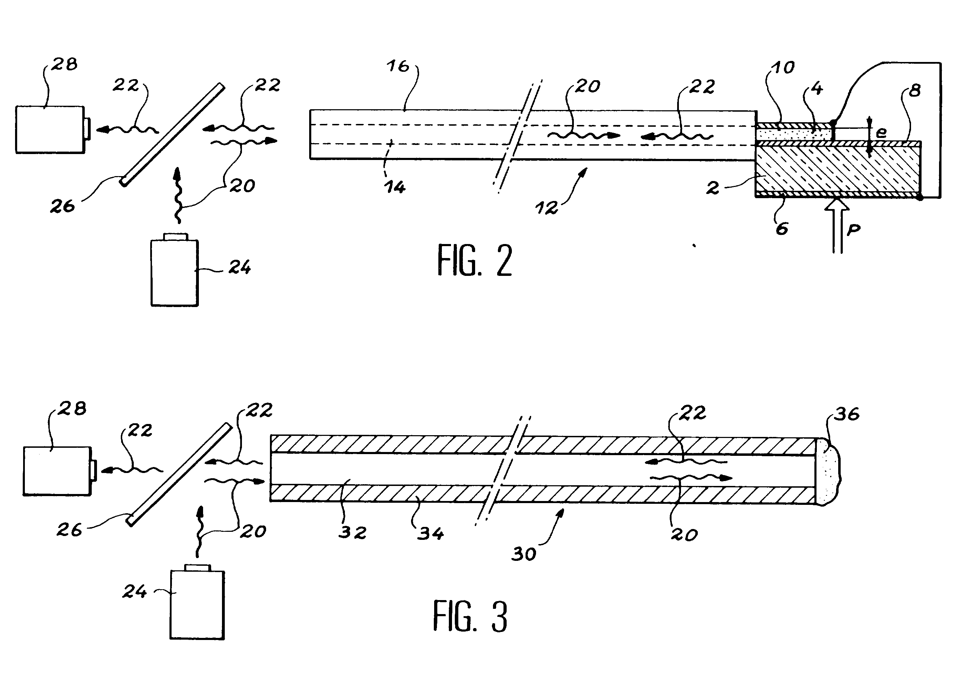

On décrit ci-après, en faisant référence aux figures 1 et 2, deux transducteurs conformes à l'invention dans lesquels les oligomères subissent un champ électrique macroscopique.

Dans les exemples représenté sur ces figures 1 et 2, les transducteurs sont associés à des cales piézoélectriques 2 pour constituer des capteurs optiques de pression.

Le transducteur schématiquement représenté sur la figure 1 comprend une couche mince 4 électriquement isolante, par exemple en polystyrène ou en PMMA, contenant des oligomères correspondant à l'une des formules a) à d) (fluorophores électro-sensibles) ou un mélange d'oligomères correspondant à plusieurs de ces formules.

Des électrodes 6 et 8 sont respectivement formées sur des faces opposées de la cale piézoélectrique 2.

Une face de la couche mince 4 est placée contre l'électrode 8 comme on le voit sur la figure 1.

L'autre face de cette couche 4 est recouverte d'une électrode 10 électriquement reliée à l'électrode 6.

L'électrode 8 est commune à la cale 2 et à la couche 4 mais électriquement isolée de l'électrode 10.

On obtient ainsi un condensateur plan constitué de la couche 4 et des électrodes 8 et 10.

Le transducteur représenté sur la figure 1 comprend aussi un guide d'onde optique 12 tel qu'une fibre optique, dont on voit le coeur 14 et la gaine optique 16 sur la figure 1.

En une extrémité de cette fibre, le coeur 14 est optiquement couplé à la couche 4 à travers l'électrode 10.

Pour ce faire, au moins la partie 18 de cette électrode 10, partie qui est placée en regard du coeur 14 de la fibre, est transparente au rayonnement 20 destiné à exciter les oligomères de la couche 4 et au rayonnement de photoluminescence 22 émis par ces oligomères lorsqu'ils sont excités par le rayonnement 20.

Cette partie ou, plus simplement, la totalité de l'électrode 10 peut être en oxyde d'indium et d'étain.

Dans l'exemple de la figure 1, le rayonnement d'excitation 20 est émis par une source lumineuse appropriée 24 (choisie en fonction des oligomères que l'on utilise) et envoyé dans le coeur de la fibre, à l'autre extrémité de celle-ci, par l'intermédiaire d'un miroir 26 apte à réfléchir ce rayonnement 20.

Ce miroir 26 est de plus transparent au rayonnement de photoluminescence 22 qui sort de cette autre extrémité et qui est détecté par des moyens de détection 28 après avoir traversé le miroir 26.

Une pression P appliquée à la cale piézoélectrique 2 engendre un champ électrique entre les électrodes 6 et 8 et donc entre les électrodes 8 et 10.

Ainsi, les oligomères contenus dans la couche 4 sont soumis à ce champ et leur rendement de photoluminescence varie.

Les moyens 28 de détection permettent de détecter les variations de photoluminescence, donc les variations du champ électrique, et par conséquent les variations de pression.

Dans la variante de réalisation qui est schématiquement représentée sur la figure 2, l'électrode 10 est opaque aux rayonnements 20 et 22.

Le coeur 14 de la fibre optique 12 est optiquement couplé à la couche 4 contenant les oligomères, par la tranche de cette couche, comme on le voit sur la figure 2.

L'épaisseur e de la couche 4 est choisie suffisamment grande pour permettre ce couplage.

Le choix de l'épaisseur e permet d'adapter l'impédance du transducteur à l'impédance de la source (qui est constituée par le capteur piézoélectrique dans les exemples des figures 1 et 2).

La valeur de surface s des faces de la couche 4, qui portent les électrodes 8 et 10, résulte d'un compromis entre la nécessité d'avoir une grande impédance, donc une petite surface, et la nécessité d'utiliser un grand nombre d'oligomères afin de limiter le vieillissement du transducteur.

En effet, l'excitation lumineuse d'un oligomère peut, à la longue, modifier celui-ci par photochimie et donc en altérer les propriétés.

Un minimum d'intensité de luminescence étant imposé par le détecteur 28 utilisé, on a intérêt à utiliser un grand nombre de molécules (oligomères) afin de réduire la fréquence des excitations que subit chacune.

Par exemple, l'oligomère du type c) (n₂=4) déposé sous vide en couche mince amorphe (la vitesse de dépôt étant d'environ 1 nm/s) avec une épaisseur de 50 nm, sur une surface de 10³ µm², voit son rendement de photoluminescence diminué de 40% lorsque le condensateur (constitué par la couche mince et les électrodes de part et d'autre de celle-ci) est chargé sous une tension de 2V, ce qui correspond à une charge électrique de 4x10⁻¹³ C.

Une telle charge peut être fournie par une cale piézoélectrique de 1 mm² seulement pour une épaisseur de 0,2 mm, cette cale étant soumise à une pression de 10⁵ Pa (10 N/cm²).

Il est à noter qu'un gain en sensibilité jusqu'à un facteur 3 peut être obtenu par l'utilisation d'un matériau dans lequel les oligomères sont tous parallèles au champ électrique (dans un matériau amorphe, les chromophores sont orientés de manière aléatoire, le champ électrique efficace moyen subi étant alors inférieur au champ appliqué).

Une telle orientation peut être obtenue, par exemple, par réalisation de couches du type Langmuir-Blodgett.

Il est aussi possible d'améliorer la sensibilité pour de faibles variations de photoluminescence en utilisant des oligomères du type a), b), c) ou d) dont les groupes R₁ et R₂ sont respectivement un groupe électro-donneur et un groupe électro-accepteur, et en orientant ces oligomères (molécules polaires) dans le même sens, par exemple par la méthode de polarisation Corona qui est décrite dans le document (4).

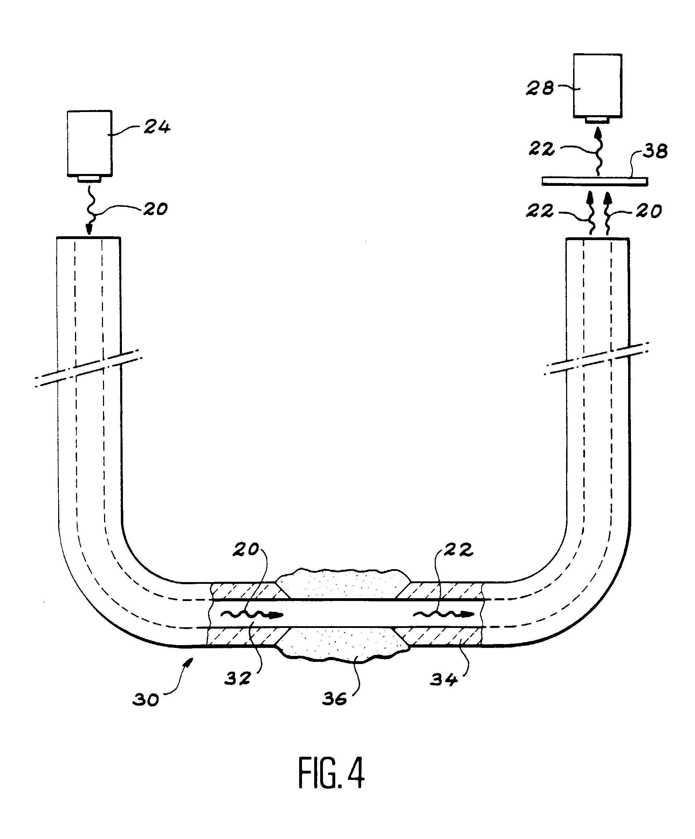

Sur les figures 3 et 4, on a représenté schématiquement des transducteurs conformes à l'invention, dans lesquels les oligomères sont susceptibles d'être soumis à un champ électrique microscopique.

De nombreux capteurs chimiques sont fondés sur des mesures optiques effectuées au moyen d'un indicateur coloré ou fluorescent qui est lié à une membrane à perméabilité sélective, cette membrane étant elle-même immobilisée à la surface ou à l'extrémité d'une fibre optique.

Le matériau sensible de tels capteurs comprend des sites qui sont capables de capter sélectivement certains ions, ces sites étant par exemple des molécules ionophores en couronne du genre de celui qui est représenté sur la figure 6 du document (5).

A chaque site est associé un fluorophore ou un chromophore dont les propriétés optiques changent lorsqu'un ion est capté.

Il s'agit souvent de l'ion H₃O⁻, pour les mesures de pH (voir le document (1)), ou de l'ion K⁺ (voir le document (5)).

Or, le champ électrique autour d'un ion est supérieur à 2x10⁵ V/cm à l'intérieur d'une sphère de rayon 12 nm, c'est-à-dire dans un volume de 7x10³ nm³.

Le volume des oligomères dont les formules sont données en a), b), c) et d) étant inférieur à 0,5 nm³, une membrane sélective contenant, en plus des molécules ionophores (comme par exemple les molécules ionophores en couronne mentionnées plus haut), de tels oligomères à une concentration de l'ordre de 10% en volume, conduit à la suppression de la photoluminescence de plus de 10³ de ces oligomères pour chaque ion capté.

Au lieu de mélanger au sein de la membrane, les oligomères et les molécules ionophores, il est possible de greffer, par des liaisons covalentes, plusieurs de ces oligomères à chaque molécule ionophore utilisée.

On voit sur la figure 3 un transducteur conforme à l'invention qui constitue un capteur chimique.

Ce capteur est destiné à détecter la présence d'espèces chimiques ionisées dans un fluide (liquide ou gaz).

Le capteur schématiquement représenté sur la figure 3 comprend un guide d'onde optique tel qu'une fibre optique 30 dont on voit le coeur 32 et la gaine optique 34 sur la figure 3.

Un matériau sensible 36, formé par une membrane contenant les oligomères et les molécules ionophores (choisies en fonction des ions à détecter), est fixé à une extrémité de la fibre optique 30 comme on le voit sur la figure 3.

Cette membrane est par exemple une membrane à perméabilité sélective à base de polyméthacrylate de méthyle (PMMA) ou de polycarbonate.

Comme dans le cas des figures 1 et 2, on place, en regard de l'autre extrémité de la fibre optique 30, le miroir 26 auquel est associé la source lumineuse 24 apte à émettre le rayonnement d'excitation 20 (destiné à exciter les oligomères) et les moyens 28 de détection du rayonnement de photoluminescence 22 émis par les oligomères excités.

Si l'espèce chimique recherchée se trouve dans le fluide analysé, les ions de cette espèce chimique se fixent aux molécules ionophores contenues dans le matériau sensible 36.

Un champ électrique microscopique est alors créé autour de ces molécules ionophores et ce champ électrique agit sur les oligomères qui sont à proximité.

Il en résulte une variation de la photoluminescence de ces oligomères et cette variation de photoluminescence est détectée grâce aux moyens de détection 28.

Dans la variante de réalisation schématiquement illustrée par la figure 4, le matériau sensible 36 n'est pas fixé à une extrémité de la fibre optique 30.

Dans le cas de la figure 4, une partie de la gaine optique 34 de la fibre 30 est supprimée dans une portion de cette fibre et remplacée par le matériau sensible 36 comprenant une membrane en polymère "dopée" par les oligomères et les molécules ionophores choisies comme on l'a vu plus haut.

Dans ce cas, on réalise un couplage par ondes évanescentes du matériau sensible avec le coeur de la fibre optique.

Dans le cas de la figure 4, le miroir sélectif 26 de la figure 3 n'est pas nécessaire : il suffit de disposer la source 24 de rayonnement d'excitation en regard d'une extrémité de la fibre optique 30 et, en regard de l'autre extrémité de celle-ci, les moyens 28 de détection du rayonnement de photoluminescence, un filtre 38, qui est apte à arrêter le rayonnement d'excitation 20 et à laisser passer le rayonnement de photoluminescence, étant interposé entre les moyens 28 de détection et cette autre extrémité de la fibre optique 30, comme on le voit sur la figure 4.

Si la fibre optique 30 est elle-même en polymère, par exemple en polystyrène, le matériau sensible 36 peut être lié chimiquement à cette fibre.

Si la fibre est en silice, l'utilisation d'un polymère-hôte silylé, pour recevoir les oligomères et les molécules ionophores, permet un accrochage de ce polymère sur la fibre.

### DOCUMENTS CITES

(1) L.A. Saari et W. R. Seitz "pH sensor based on immobilized fluoresceinamine" Annals of Chemistry 1982 (54) page 821 (1982).
(2) J. P. Goedgebuer et A. Hamel, "Coherence multiplexing using electro-optic modulators ..." IEEE Journal of Quantum Electronics 23 (12) page 2224 (1987).
(3) P. Dyreklev, O. Inganäs, J. Paloheimo et H. Stubb, "Photoluminescence quenching in a polymer thin-film field-effect luministor" Journal of Applied Physics 71 (6) page 2816 (1992).
(4) D.S. Chemla et J. Zyss, "Nonlinear optical properties of organic molecules and crystals" (Academic, New-York, 1986) vol.2.
(5) F. Alava-Moreno, R. Pereiro-Garcia, M.E. Diaz-Garcia and A. Sanz-Medel, "A comparative study of two different approaches for active optical sensing of potassium with a chromoionophore" Sensors and Actuators B 11 page 413 (1993).

## Revendications

1. Transducteur électro-optique comprenant un élément électro-sensible (4, 36) qui est sujet à l'émission d'un rayonnement de photoluminescence (22) lorsqu'il est éclairé par un rayonnement d'excitation (20), ce transducteur étant caractérisé en ce que l'élément électro-sensible (4, 36) comprend des oligomères conjugués photoluminescents, ces derniers étant sujets à une variation de leur rendement de photoluminescence en présence d'un champ électrique.

2. Transducteur selon la revendication 1, caractérisé en ce que les oligomères sont choisis dans le groupe comprenant les oligomères de paraphénylène et les oligomères de thiophène, le nombre N de monomères de ces oligomères étant tel que M≤N≤12, avec M=8.

3. Transducteur selon la revendication 1, caractérisé en ce que les oligomères sont choisis dans le groupe comprenant les oligomères de paraphénylène-éthénylène et les oligomères de thiophène-éthénylène, le nombre N de monomères de ces oligomères étant tel que M≤N≤10, avec M=4.

4. Transducteur selon l'une quelconque des revendications 2 et 3, caractérisé en ce que le nombre de monomères de ces oligomères est égal à M.

5. Transducteur selon l'une quelconque des revendications 1 à 4, caractérisé en ce que l'élément électro-sensible comprend une couche (4) contenant lesdits oligomères et des moyens (8, 10) d'application d'un champ électrique macroscopique à cette couche.

6. Transducteur selon la revendication 5, caractérisé en ce que les moyens d'application du champ électrique comprennent deux électrodes (8, 10) respectivement placées de part et d'autre de la couche (4).

7. Transducteur selon la revendication 6, caractérisé en ce qu'au moins une partie (18) de l'une (10) des deux électrodes est transparente au rayonnement d'excitation et au rayonnement de photoluminescence.

8. Transducteur selon l'une quelconque des revendications 1 à 4, caractérisé en ce que l'élément électro-sensible (36) comprend en outre des molécules ionophores aptes à capter sélectivement des ions déterminés, chaque ion capté créant un champ électrique microscopique auquel sont soumis lesdits oligomères.

9. Transducteur selon la revendication 8, caractérisé en ce qu'il comprend en outre un guide d'onde optique (30) destiné à la propagation du rayonnement d'excitation et du rayonnement de photoluminescence et en ce que l'élément électro-sensible (36) est fixé à une extrémité de ce guide d'onde.

10. Transducteur selon la revendication 8, caractérisé en ce qu'il comprend en outre un guide d'onde optique (30) destiné à la propagation du rayonnement d'excitation et du rayonnement de photoluminescence et en ce que l'élément électro-sensible est fixé sur le pourtour du guide d'onde, le couplage de l'élément électro-sensible (36) avec ce guide d'onde étant un couplage par ondes évanescentes.

## Patentansprüche

1. Elektrooptischer Wandler mit einem elektrosensiblen Element (4, 36), das eine Photolumineszenzstrahlung (22) emittiert, wenn es durch eine Erregungs- bzw. Anregungsstrahlung (20) beleuchtet wird, wobei dieser Wandler
**dadurch gekennzeichnet** ist, daß das elektrosensible Element (4, 36) photolumineszente konjugierte Oligomere umfaßt und diese letzteren bei Vorhandensein eines elektrischen Feldes einer Veränderung ihrer Photolumineszenzleistung unterworfen sind.

2. Wandler nach Anspruch 1, dadurch gekennzeichnet, daß die oligomere aus der Gruppe gewählt werden, die die Paraphenylenoligomere und die Thiophenoligomere umfaßt, wobei die Anzahl N von Monomeren dieser Oligomere so ist, daß M≤N≤12, mit M=8.

3. Wandler nach Anspruch 1, dadurch gekennzeichnet, daß die Oligomere aus der Gruppe gewählt werden, die die Paraphenylenethenylen-Oligomere und die Thiophen-ethylen-Oligomere umfaßt, wobei die Anzahl N von Monomeren dieser oligomere so ist, daß M≤N≤10, mit M=4.

4. Wandler nach einem der Ansprüche 2 und 3, dadurch gekennzeichnet, daß die Anzahl der Monomere dieser oligomere gleich M ist.

5. Wandler nach einem der Ansprüche 1 bis 4, dadurch gekennzeichnet, daß das elektrosensible Element eine die besagten Oligomere enthaltende Schicht (4) und Einrichtungen (8, 10) zur Anwendung eines makroskopischen elektrischen Feldes auf diese Schicht umfaßt.

6. Wandler nach Anspruch 5, dadurch gekennzeichnet, daß die Einrichtungen zur Anwendung des elektrischen Feldes zwei Elektroden (8, 10) enthält, die beiderseits der schicht (4) angeordnet sind.

7. Wandler nach Anspruch 6, dadurch gekennzeichnet, daß wenigstens ein Teil (18) von einer (10) der beiden Elektroden durchlässig ist für die Anregungsstrahlung und für die Photolumineszenzstrahlung.

8. Wandler nach einem der Ansprüche 1 bis 4, dadurch gekennzeichnet, daß das elektrosensible Element (36) außerdem ionophore Moleküle enthält, die selektiv bestimmte Ionen einfangen können, wobei jedes eingefangene Ion ein mikroskopisches elektrisches Feld erzeugt, dem die besagten Oligomere ausgesetzt sind.

9. Wandler nach Anspruch 8, dadurch gekennzeichnet, daß er außerdem einen optischen Wellenleiter (30) enthält, der der Ausbreitung bzw. Fortpflanzung der Erregungs- bzw. Anregungsstrahlung und der Photolumineszenzstrahlung dient, und dadurch, daß das elektrosensible Element (36) an einem Ende dieses Wellenleiters befestigt ist.

10. Wandler nach Anspruch 8, dadurch gekennzeichnet, daß es außerdem einen optischen Wellenleiter (30) enthält, der der Fortpflanzung der Erregungsstrahlung und der Photolumineszenzstrahlung dient, und dadurch, daß das elektrosensible Element auf dem Umfang des Wellenleiters befestigt ist, wobei die Kopplung des elektrosensiblen Elements (36) mit diesem Wellenleiter eine Kopplung durch abklingende Wellen ist.

## Claims

1. Electrooptical transducer incorporating an electrosensitive element (4, 36) exposed to the emission of a photoluminescence radiation (22) when illuminated by an excitation radiation (20), said transducer being characterized in that the electrosensitive element (4, 36) comprises photoluminescent conjugate oligomers, which are exposed to a variation of their photoluminescence efficiency in the presence of an electrical field.

2. Transducer according to claim 1, characterized in that the oligomers are chosen from within the group including paraphenylene oligomers and thiophene oligomers, the number N of monomers of said oligomers being such that M≤N≤12, with M=8.

3. Transducer according to claim 1, characterized in that the oligomers are chosen from within the group including paraphenylene-ethenylene oligomers and thiophene-ethenylene oligomers, the number N of monomers of said oligomers being such that M≤N≤1, with M=4.

4. Transducer according to either of the claims 2 and 3, characterized in that the number of monomers of said oligomers is equal to M.

5. Transducer according to any one of the claims 1 to 4, characterized in that the electrosensitive element comprises a film (4) containing said oligomers and means (8, 10) for applying a macroscopic electrical field to said film.

6. Transducer according to claim 5, characterized in that the means for applying the electrical field comprise two electrodes (8, 10) respectively placed on either side of the film (4).

7. Transducer according to claim 6, characterized in that at least a portion (18) of one (10) of the two electrodes is transparent to the excitation radiation and to the photoluninescence radiation.

8. Transducer according to any one of the claims 1 to 4, characterized in that the electrosensitive element (36) also comprises ionophore molecules able to selectively sense the given ions, each sensed ion creating a microscopic electrical field to which are exposed said oligomers.

9. Transducer according to claim 8, characterized in that it also comprises an optical waveguide (30) for the propagation of the excitation radiation and the photoluminescence radiation and in that the electrosensitive element (36) is fixed to one end of said waveguide.

10. Transducer according to claim 8, characterized in that it also comprises an optical waveguide (30) for the propagation of the excitation radiation and the photoluminescence radiation and in that the electrosensitive element is fixed to the periphery of the waveguide, the coupling of the electrosensitive element (36) to said waveguide being a coupling by evanescent waves.
